# EUROPÄISCHE PATENTSCHRIFT

(11) **EP 2 625 443 B1**
(45) Veröffentlichungstag und Bekanntmachung des Hinweises auf die Patenterteilung: **17.12.2014**
(21) Anmeldenummer: 11752216.9
(22) Anmeldetag: 02.09.2011
(51) Int. Cl.: F16H 61/00

(54) **GETRIEBESTEUERGERÄT**
TRANSMISSION CONTROL DEVICE
APPAREIL DE COMMANDE DE BOÎTE DE VITESSE

(30) Priorität: 06.10.2010 DE 102010042019
(43) Veröffentlichungstag der Anmeldung: 14.08.2013
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2011/065208
(87) Internationale Veröffentlichungsnummer: WO 2012/045534

(56) Entgegenhaltungen:
- EP-A2- 0 944 298
- DE-C1- 19 734 032
- FR-A- 1 266 244
- GB-A- 2 199 203

## Beschreibung

### Stand der Technik

Steuergeräte, insbesondere Getriebesteuergeräte, die zum Beispiel in automatischen Getrieben von Kraftfahrzeugen eingesetzt werden, sind hohen mechanischen Belastungen ausgesetzt. Die Steuergeräte werden zum Teil innerhalb des automatischen Fahrzeuggetriebes verbaut und sind dadurch einem äußerst aggressiven Medium wie zum Beispiel der Getriebeflüssigkeit (ATF = Automatic Transmission Fluid) ausgesetzt. Steuergeräte für Kraftfahrzeuggetriebe umfassen im Wesentlichen einen Schaltungsträger, der zum Beispiel über elektrische Kontaktierungen in Gestalt von Bondverbindungen mit in das Gehäuse des Steuergerätes eingeglasten Durchkontaktierungen so zum Beispiel Ni-Fe-Pins kontaktiert werden. Die eingeglasten Durchkontaktierungen weisen insbesondere den Vorteil auf, dass diese hermetisch dicht sind und eine nach außen geführte elektrische Kontaktierung möglich ist, sodass die Durchkontaktierungen der Getriebesteuergeräte mit außerhalb des Getriebes angeordneten elektrischen Komponenten wie zum Beispiel Leiterplatten und Stanzgitter kontaktiert werden können.

Die heute in der Regel eingesetzten eingeglasten Durchkontaktierungen sind relativ aufwendig herzustellende Bauteile. Zum Einglasen der Durchkontaktierungen in Form von stiftförmigen Anschlusspins sind spezielle Bodenplatten, Binnenleisten und Deckel aus metallischem Material erforderlich, die relativ teuer sind.

Aus der EP 0 944 298 A2 ist eine Steuergerät mit einem Bodenteil, einem Deckelteil, einem Schaltungsträger und einer Medienbefüllung bekannt, bei dem das Deckelteil einen in einer Verformungsrichtung verformbaren Abschnitt aufweist. Elektrische Durchführungen sind durch Seitenwände des Steuergeräts hindurchgeführt.

Aus der FR 1 266 244 und aus der GB 2 199 203 A sind Steuergeräte mit einem Bodenteil und einem darauf angeordneten Deckelteil bekannt, die eine Medienbefüllung aufweisen.

### Offenbarung der Erfindung

Erfindungsgemäß wird vorgeschlagen, ein Steuergerät insbesondere für ein Getriebe, so zum Beispiel ein automatisches Fahrzeuggetriebe unter Verzicht auf metallische Bauteile zum Beispiel aus einem Deckelteil und einem Bodenteil, die beide aus Kunststoff gefertigt werden können, anzugeben. Das Bodenteil des erfindungsgemäß vorgeschlagenen Steuergerätes wird als Kunststoffboden gefertigt mit abgedichtet in diesem eingebetteten Durchkontaktierungen in Stiftform. Die in den Kunststoffboden eingebetteten Durchkontaktierungen sind in den Kunststoffboden dicht eingespritzt oder eingesteckt, wobei die einzelnen Durchkontaktierungen gegeneinander elektrisch isoliert sind. Mittels der Durchkontaktierungen, die im Kunststoffboden des Bodenteils des erfindungsgemäß vorgeschlagenen Steuergerätes integriert sind, wird der im Inneren des Steuergerätes angeordnete Schaltungsträger mit einer außerhalb des Steuergerätes befindlichen Modul-Aufbauverbindungstechnik, so zum Beispiel durch Löten oder auf eine andere stoffschlüssige Verbindungsweise, elektrisch kontaktiert. Innerhalb des erfindungsgemäß vorgeschlagenen Steuergerätes ist der Schaltungsträger mit der Durchkontaktierung in Pinform beispielsweise über Bonddrähte elektrisch verbunden.

Der im Inneren des erfindungsgemäß vorgeschlagenen Steuergerätes befindliche Schaltungsträger wird beispielsweise mittels einer Klebeschicht am Bodenteil befestigt. Der Hohlraum des erfindungsgemäß vorgeschlagenen integrierten Steuergerätes, der durch das Deckelteil und das Bodenteil begrenzt ist, wird mit einer Medienfüllung versehen. Bei der Medienfüllung handelt es sich beispielsweise über ein luftfrei eingebrachtes isolierendes Wärmeleitöl oder um ein niedrigviskoses Wärmeleitgel. Das Deckelteil und das Bodenteil des erfindungsgemäß vorgeschlagenen Steuergerätes können durch stoffschlüssige Verbindungstechniken wie zum Beispiel Verschweißen oder Verkleben miteinander dicht verbunden sein oder es besteht die Möglichkeit, das Deckelteil und das Bodenteil miteinander zu verschrauben und eine öldichte Dichtung zwischen Bodenteil und Deckelteil einzubringen. Werden das Deckelteil und das Bodenteil miteinander gefügt, ist anzustreben, einen Differenzdruck von 0 zwischen dem Innenraum, d.h. dem Hohlraum, der von Deckelteil und Bodenteil begrenzt ist, und dem das Deckelteil und das Bodenteil umgebenden Außenraum herzustellen.

Beim erfindungsgemäß vorgeschlagenen Steuergerät ist das Deckelteil derart ausgebildet, dass dieses sich membranmäßig verformen kann, wenn die Medienfüllung, so zum Beispiel elektrisch isolierendes Wärmeleitöl sich erwärmt.

Die Medienbefüllung des Hohlraumes, begrenzt durch das Bodenteil und das Deckelteil, leitet die Wärme direkt ab und kann im Idealfall durch konvektive Fluidströmung die Entwärmung des Schaltungsträgers befördern. Durch ein beispielsweise membranartiges Deckelteil ist sichergestellt, dass ein Innendruck und ein Außendruck - abgesehen vom Verformungsdruck der Deckenfläche - im Wesentlichen einander entsprechen, d.h. an den beispielsweise in das Bodenteil oder auch in das Deckelteil eingebrachten dichtend angeordneten Durchkontaktierungen kein Differenzdruck anliegt, der zu einem Medienaustausch zwischen Getriebeöl und Wärmeleitöl führen könnte. Das Wärmeleitöl übernimmt die Funktion des derzeit eingesetzten Gels, d.h. mittels des Wärmeleitöls lässt sich eine Schwingungsbedämpfung beziehungsweise eine Schwingungsstabilisierung von Bauteilen, zum Beispiel des Schaltungsträgers und den darauf angeordneten Halbleiterbauelementen und auch der Bonddrähte, d.h. der elektrischen Verbindung zwischen den Schaltungsträgerkomponenten und den Durchkontaktierungen erreichen.

Die Farbe des Deckelteils wird zum Beispiel schwarz sein zur besseren Wärmeabstrahlung; Das Deckelteil und die Medienbefüllung können transparent ausgebildet sein, was eine einfache visuelle Sichtprüfung nach der Montage des Getriebesteuergerätes ermöglicht.

Das erfindungsgemäß vorgeschlagene Steuergerät ist aus einem becherförmig ausgebildeten Bodenteil und einer dieser abdeckenden Folienschicht gefertigt. Die elektronischen Halbleiterbauelemente werden bei sämtlichen Ausführungsvarianten des erfindungsgemäß vorgeschlagenen Steuergerätes vorzugsweise mit ihrer wärmeabgebenden Flächen nicht zum Schaltungsträger, sondern hin zur Medienbefüllung orientiert montiert.

Schließlich kann in einer weiteren Ausführungsvariante des erfindungsgemäß vorgeschlagenen Steuergerätes beispielsweise im Bodenteil mindestens eine später wieder verschließbare Öffnung vorgesehen werden. Durch diese später verschließbare Öffnung kann das Innere des Steuergerätes mit Medium, so zum Beispiel dem Wärmeleitöl, befüllt werden oder auch eine Spülung des Innenraumes durch ein Medium erfolgen und damit auch eine Entlüftung des Hohlraumes, begrenzt durch das Bodenteil und das Deckelteil, erreicht werden.

Die Durchkontaktierungen im Bodenteil werden beispielsweise mit den elektronischen Bauelementen des Schaltungsträgers über Bondverbindungen elektrisch kontaktiert und außerhalb des Bodenteiles mit einer Modul-Aufbau-Verbindungstechnik beispielsweise über stoffschlüssige Fügeverfahren so zum Beispiel das Schweißen und das Löten miteinander elektrisch kontaktiert. Neben stoffschlüssigen Fügeverfahren, wie den erwähnten Schweißverfahren und dem Lötverfahren oder auch dem Hartlötverfahren besteht die Möglichkeit, Durchkontaktierungen auch über Kaltkontaktierungen und Kaltumformung mit der Modul-Aufbau-Verbindungstechnik elektrisch zu kontaktieren. Unter Modul-Aufbau-Verbindungstechnik wird im vorliegenden Zusammenhang die elektrische Kontaktierung der Durchkontaktierungen mit einer Leiterplatte, einer Flexfolie, einem Stanzgitter oder dergleichen verstanden.

### Kurze Beschreibung der Zeichnungen

Anhand der Zeichnung wird die Erfindung nachgehend eingehender beschrieben.

Es zeigt:
- Figur 1: ein Steuergerät mit einer Medienfüllung befüllt aus Bodenteil und Deckelteil, welches eine flexible Deckenfläche und formstabile Seitenwände umfasst,
- Figur 2: ein Steuergerät mit einer formstabil ausgelegten Deckenfläche und balkartig ausgebildeten Seitenbereichen,
- Figur 3: die Ausführungsmöglichkeit des erfindungsgemäß vorgeschlagenen Steuergerätes mit becherförmig ausgebildetem Bodenteil und einer dünn ausgelegten Folie und
- Figur 4: ein Bodenteil eines Steuergerätes, versehen mit Öffnungen zur Medienbefüllung.

### Ausführungsformen der Erfindung

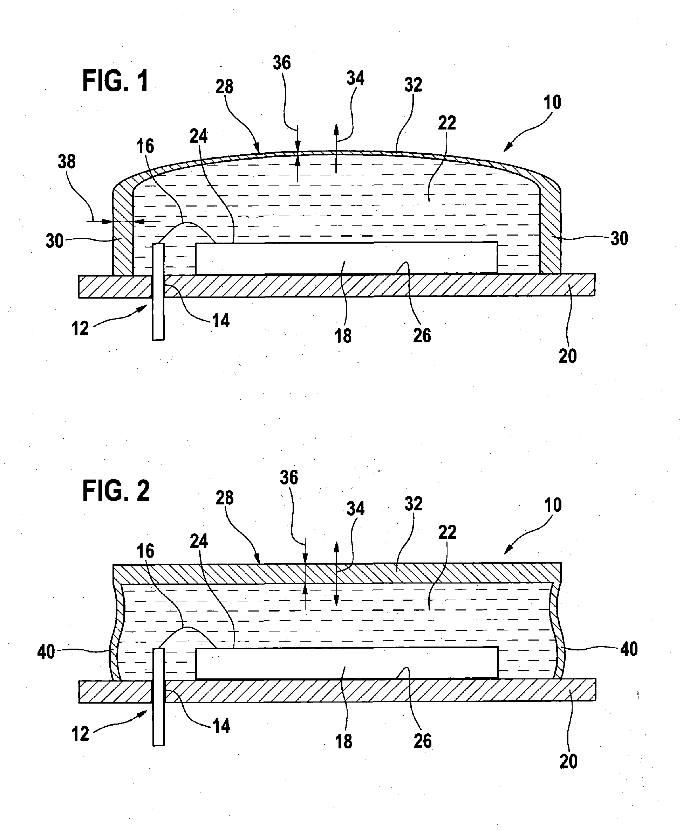

Aus der Darstellung der nur der Erläuterung dienenden Figur 1 geht hervor, dass ein integriertes Steuergerät, insbesondere für ein Getriebe oder ein automatisches Getriebe eines Kraftfahrzeuges in einem Bodenteil 20, welches bevorzugt aus Kunststoffmaterial gefertigt wird, mindestens eine Durchkontaktierung in Stiftform aufweist. Die einzelnen stiftförmigen ausgebildeten Durchkontaktierungen 12 sind elektrisch gegeneinander isoliert, wobei die stiftförmigen Durchkontaktierungen 12 lötbar oder laserverschweißbar sowie eine Bondverbindung ermöglichend, ausgebildet sind. Die Durchkontaktierungen 12 in Stiftform sind entweder in das aus Kunststoff gefertigte Bodenteil 20 eingesteckt oder mittels einer Abdichtung 14 in dieses eingespritzt. Die stiftförmig ausgebildeten Durchkontaktierungen 12 stehen über elektrische Verbindungen 16 mit den elektrischen Bauelementen in Verbindung, die an der Oberseite eines Schaltungsträgers 18 angeordnet sind. Das Bodenteil 20 ist durch ein Deckelteil 28, welches ebenfalls aus Kunststoffmaterial gefertigt ist, verschlossen. Eine dichtende Verbindung zwischen dem Bodenteil 20 und dem Deckelteil 28 kann beispielsweise durch Verschweißen oder Verkleben oder Verschrauben mittels einer öldichten Abdichtung herbeigeführt werden. Das Innere des Hohlraumes, der durch das Bodenteil 20 und das Deckelteil begrenzt ist, ist mit einer Medienfüllung 22 versehen. Bei der Medienfüllung 22 kann es sich beispielsweise um ein elektrisch isolierendes Wärmeleitöl oder um ein niedrigviskoses Wärmeleitgel handeln.

Des Weiteren befindet sich im Inneren des Hohlraums, der durch das Bodenteil 20 und das Deckelteil 28 begrenzt ist, der Schaltungsträger 18, der mittels einer Klebeschicht 26 mit der dem Deckelteil 28 zuweisenden Seite des Schaltungsträgers verklebt ist.

Der Schaltungsträger 18 leitet Wärme in das Bodenteil 20 ein und gibt andererseits Wärme auf der Oberseite an die Medienbefüllung 22 ab.

In der Figur 1 ist eine Deckenfläche 32 des Deckelteils 28 in einer sehr dünnen Wandstärke 36 ausgebildet, sodass bei steigender Temperatur und sich anschließender Erwärmung der Medienfüllung 22 und deren Ausdehnung eine Verformung der Deckenfläche 32 in Verformungsrichtung 34 erfolgen kann. Während die Deckenfläche 32 in der ersten Dicke 36 ausgebildet ist, sind Deckelseitenwände 30 formstabil ausgelegt, d.h. in einer zweiten Dicke 38, welche die erste Dicke 36 übersteigt, ausgebildet.

Durch die unterschiedlichen Dicken 36, bzw. 38 besteht die Möglichkeit, dass sich die Deckenfläche 32 des Deckelteiles 28 nach außen in Verformungsrichtung 34 wölbt, ohne dass der Druck im Inneren des Steuergerätes ansteigt.

In der Figur 2 ist das Deckelteil 28 in kinematischer Umkehr gefertigt. Dies bedeutet, dass in der in Figur 2 dargestellten Ausführungsvariante die Deckelfläche 32 in der zweiten Dicke 38 ausgebildet ist, d.h. formstabil, näherungsweise starr ausgebildet ist. Gegenüber der in Figur 1 dargestellten Ausführungsvariante sind bei der in Figur 2 dargestellten Ausführungsvariante Deckelseitenwände als balgartig verformbar, vgl. Position 40, ausgebildet, sodass eine Dehnung derselben in Verformungsrichtung 34 gemäß des Doppeltpfeils in Figur 2, in beide Richtungen erfolgen kann. Analog zur Darstellung gemäß Figur 1 ist bei der Figur 2 ein Schaltungsträger 18 vorgesehen, ferner sind die stiftförmig ausgebildeten Durchkontaktierungen 12 im Bodenteil 20 dichtend eingelassen oder in dieses eingespritzt oder eingesteckt. Das Innere des Steuergerätes gemäß der in Figur 2 dargestellten Ausführungsvariante ist ebenfalls mit der Medienfüllung 22 befüllt, jedoch verformt sich bei Erwärmung dieser nicht die Deckenfläche 32, sondern die Deckelseiten 40 werden gemäß der Verformungsrichtung 34 im Wesentlichen in vertikale Richtung gedehnt.

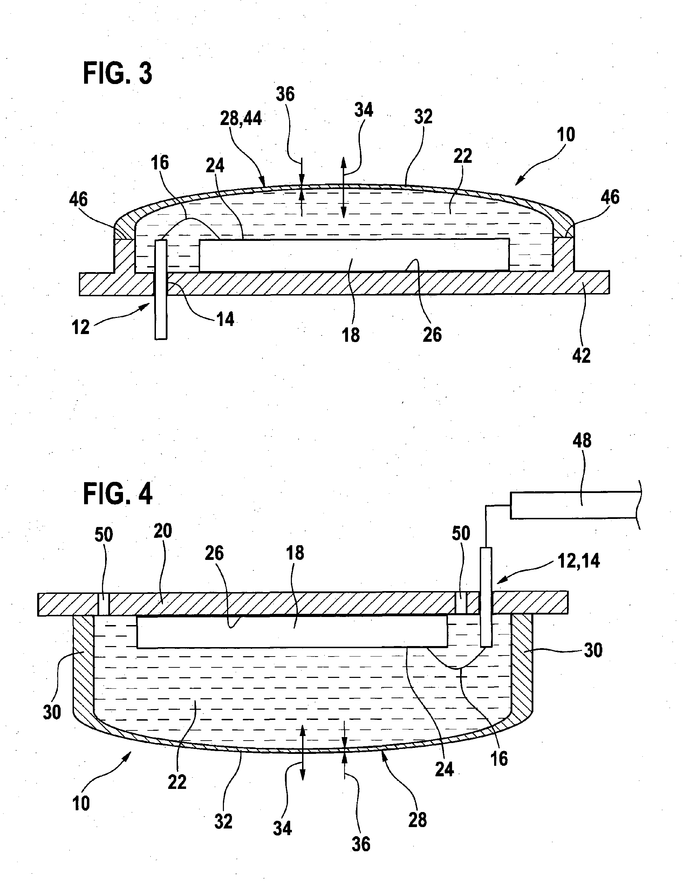

Aus der Darstellung gemäß Figur 3 geht eine Ausführungsmöglichkeit des erfindungsgemäß vorgeschlagenen Steuergerätes hervor.

Aus der Darstellung gemäß Figur 3 geht hervor, dass das integrierte Steuergerät 10 ein becherförmig ausgebildetes Bodenteil 42 aufweist, welches mit einer sehr dünnen Folienschicht 44 verschlossen ist. Die Folienschicht 44 ist an Verbindungsstellung 46 mit der Oberseite des becherförmig ausgebildeten Bodenteiles 42 verbunden. Im Hohlraum, der durch die Folienschicht 44 und dem becherförmigen Boden 42 begrenzt ist, befindet sich eine Medienfüllung analog zu den Ausführungsvarianten gemäß der Figuren 1 und 2 wie oben stehend beschrieben.

Im Inneren des Steuergerätes befindet sich der Schaltungsträger 18, der über mindestens eine elektrische Verbindung 16 mit mindestens einer Durchkontaktierung 12 elektrisch verbunden ist, die in das becherförmige Bodenteil 42 eingesteckt, eingespritzt oder mittels einer Abdichtung dichtend eingelassen ist. Die mindestens eine stiftförmig ausgebildete Durchkontaktierung 12 steht mit einer nicht näher dargestellten außen liegenden Modul-Aufbau-Verbindungstechnik so zum Beispiel in Gestalt einer Leiterplatte, einer Flexfolie, eines Stanzgitters oder dergleichen elektrisch in Verbindung.

Durch die membranartig wirkende Folienschicht 44 ist sichergestellt, dass der Innen- und der Außendruck - abgesehen vom Verformungsdruck des Deckelteils - im Wesentlichen gleich sind. Dies bedeutet, dass an den in das Bodenteil 20 beispielsweise eingelassene Durchkontaktierungen 12 kein Differenzdruck anliegt, der zu einem Medienaustausch zwischen dem Automatic Transmission Fluid (ATF), d.h. dem Getriebeöl und der im Hohlraum bevorrateten Medienfüllung 22 führen könnte.

Die Medienfüllung 22 beispielsweise in Gestalt eines elektrisch isolierenden Wärmeleitöls übernimmt die Funktion heute eingesetzter Gele insbesondere im Hinblick darauf, dass eine Schwingungsbedämpfung beziehungsweise Stabilisierung von Bauteilen und elektrische Verbindungen 16 insbesondere erfolgen kann.

Gemäß der vorstehend gezeigten Ausführungsvariante der Figur 3 handelt es sich insbesondere um ein Bodenteil 42 beziehungsweise Deckelteile 28, die aus Kunststoffmaterial gefertigt sind.
Aus der Darstellung gemäß Figur 4 geht ein Steuergerät hervor, bei dem im Bodenteil 20 mindestens eine Öffnung 50 zur Befüllung beziehungsweise Entleerung des Innenraumes des Steuergerätes vorgesehen ist. Durch die mindestens eine Öffnung 50 - hier ausgebildeten Bodenteil 20 - kann eine Befüllung des Innenraumes des Steuergerätes mit Wärmeleitöl beziehungsweise eine Spülung desselben Innenraumes oder auch eine Entlüftung des Innenraumes erfolgen. Das in Figur 4 dargestellte Steuergerät entspricht im Wesentlichen dem in Figur 1 dargestellten Steuergerät, umfassend ein Deckelteil 28 mit einer in einer ersten Dicke 36 ausgebildeten Deckelfläche 32 und dem plan ausgebildeten Bodenteil 20. In der in Figur 4 dargestellten Ausführungsvariante sind die Seitenwandbereiche 30 des Deckelteiles 28 formstabil ausgeführt, d.h. weisen im Vergleich zur ersten Dicke 36 der Deckelfläche 32 eine größere Dicke so zum Beispiel die zweite Dicke 38 auf. Der Vollständigkeit halber sei erwähnt, dass die entwärmende Oberfläche 24 des Schaltungsträgers 18 der Medienfüllung 22 zugewandt ist, und der Schaltungsträger 18 mit seiner gegenüberliegenden Seite mittels einer Klebeschicht 26 mit dem Bodenteil 20 stoffschlüssig verbunden ist.

In der Darstellung gemäß Figur 4 ist schematisch angedeutet, dass die mindestens eine Durchkontaktierung 12 - abgedichtet im Bodenteil 20 - mit einer Modul-AufbauVerbindungstechnik 48 elektrisch verbunden ist. Bei der Modul-Aufbau-Verbindungstechnik 48 kann es sich zum Beispiel um eine außerhalb des integrierten Steuergerätes 10 liegende Leiterplatte, Flexfolie oder um ein Stanzgitter handeln.

Mit der erfindungsgemäß vorgeschlagenen Lösung besteht die Möglichkeit, ein aus Kunststoff gefertigtes Steuergerät bereitzustellen, welches nicht im Wege des Duroplastumspritzens (Molden), sondern durch einfachste, sehr kostengünstig fertiggespritzte Gehäuseteile gebildet werden kann. Damit bei Temperaturveränderungen und damit Druckanstieg, beziehungsweise Druckabfall im Inneren des Steuergerätes gegenüber der Umgebung kein Pumpeffekt entsteht, ist ein Druckausgleich dadurch möglich, dass zumindest das Deckelteil 28 verformbar ausgebildet ist, sodass die Wärmedehnung kompensiert werden kann. Dadurch kann einerseits umgangen werden, ein teures Duroplastumspritzen vorzunehmen, andererseits im Innenraum des Steuergerätes aufgrund der Wärmeableitung eine Medienfüllung 22 vorgesehen sein kann und aufgrund der Verformbarkeit des Deckelteiles 28 stiftförmige Durchkontaktierungen 12 eingesetzt werden können, die nicht vollständig gasdicht im Bodenteil 20 verbaut werden müssen.

## Patentansprüche

1. Steuergerät, insbesondere integriertes Steuergerät für Getriebe von Kraftfahrzeugen, mit einem Bodenteil (20), (42) und einem Deckelteil (28), einem Schaltungsträger (18) und mindestens einer Durchkontaktierung (12) zum Anschluss an eine Modul-Aufbau-Verbindungstechnik (48), wobei das Deckelteil (28) und das Bodenteil (20) eine Medienfüllung (22) aufnehmen und das Deckelteil (28) zumindest einen in einer Verformungsrichtung (34) verformbaren Abschnitt (32), (40), (44) aufweist, **dadurch gekennzeichnet, dass** das Deckelteil (28) eine Folie (44) ist, die an einem becherförmigen Bodenteil (42) befestigt ist und das Bodenteil (20) als Kunststoffbauteil beschaffen ist, in welches mindestens eine Durchkontaktierung (12) dicht eingebettet ist.

2. Steuergerät gemäß Anspruch 1, **dadurch gekennzeichnet, dass** der Schaltungsträger (18) mittels einer Kleberschicht (26) auf dem Bodenteil (20) befestigt ist und eine wärmeabgebende Seite (24) des Schaltungsträgers (18) der Medienfüllung (22) zuweist.

3. Steuergerät gemäß Anspruch 1, **dadurch gekennzeichnet, dass** die Medienfüllung (22) ein elektrisch isolierendes Wärmeleitöl oder niedrigviskoses Wärmeleitgel ist.

4. Steuergerät gemäß Anspruch 1, **dadurch gekennzeichnet, dass** das Deckelteil (28) eine in ersten Wanddicke (36) ausgebildete, auslenkbare Deckelfläche (32) und formstabile Deckelseitenwände (30) aufweist.

5. Steuergerät gemäß Anspruch 1, **dadurch gekennzeichnet, dass** sich im Bodenteil (20) und/oder im Deckelteil (28) Öffnungen (50) befinden, über welche ein Hohlraum zwischen dem Deckelteil (28) und dem Bodenteil (20) mit der Medienfüllung (22) befüllbar oder der Hohlraum spülbar ist.

6. Steuergerät gemäß Anspruch 1, **dadurch gekennzeichnet, dass** die Durchkontaktierungen (12) mit der Modul-Aufbau-Verbindungstechnik (48) insbesondere einer Leiterplatte, einer Flexfolie oder einem Stanzgitter durch Schweißen oder Löten oder durch Kaltkontaktierung elektrisch verbunden sind.

## Claims

1. Control device, in particular integrated control device, for transmissions of motor vehicles, having a base part (20), (42) and a cover part (28), a circuit carrier (18) and at least one via (12) for connecting to a module structure connecting system (48), wherein the cover part (28) and the base part (20) accommodate a media filler (22), and the cover part (28) has at least one section (32), (40), (44) which can be deformed in a deformation direction (34), **characterized in that** the cover part (28) is a film (44) which is attached to a beaker-shaped base part (42), and the base part (20) is constructed as a plastic component into which at least one via (12) is embedded in a sealed fashion.

2. Control device according to Claim 1, **characterized in that** the circuit carrier (18) is attached to the base part (20) by means of an adhesive layer (26), and a heat-outputting side (24) of the circuit carrier (18) faces the media filler (22).

3. Control device according to Claim 1, **characterized in that** the media filler (22) is an electrically insulating thermally conductive oil or low-viscosity thermally conductive gel.

4. Control device according to Claim 1, **characterized in that** the cover part (28) has a deflectable cover surface (32) which is embodied in a first wall thickness (36), and dimensionally stable cover side walls (30).

5. Control device according to Claim 1, **characterized in that** openings (50) are located in the base part (20) and/or in the cover part (28), via which openings (50) a cavity between the cover part (28) and the base part (20) can be filled with the media filler (22), or the cavity can be rinsed.

6. Control device according to Claim 1, **characterized in that** the vias (12) are electrically connected to the module structure connecting system (48), in particular a printed circuit board, a flex film or a punched grill, by welding or soldering or by cold contacting.

## Revendications

1. Appareil de commande, en particulier appareil de commande intégré pour transmission de véhicules automobiles, comprenant une partie de fond (20), (42) et une partie de couvercle (28), un support de circuit (18) et au moins un trou d'interconnexion (12) pour le raccordement à un système de connexion de structure modulaire (48), la partie de couvercle (28) et la partie de fond (20) recevant un milieu de remplissage (22) et la partie de couvercle (28) comprenant au moins une portion (32), (40), (44) déformable dans une direction de déformation (34), **caractérisé en ce que** la partie de couvercle (28) est une feuille (44) qui est fixée à une partie de fond (42) en forme de bécher et la partie de fond (20) est prévue en tant que composant en plastique dans lequel au moins un trou d'interconnexion (12) est incorporé de manière étanche.

2. Appareil de commande selon la revendication 1, **caractérisé en ce que** le support de circuit (18) est fixé sur la partie de fond (20) au moyen d'une couche adhésive (26) et un côté émetteur de chaleur (24) du support de circuit (18) est tourné vers le milieu de remplissage (22).

3. Appareil de commande selon la revendication 1, **caractérisé en ce que** le milieu de remplissage (22) est une huile thermoconductrice électriquement isolante ou un gel thermoconducteur de faible viscosité.

4. Appareil de commande selon la revendication 1, **caractérisé en ce que** la partie de couvercle (28) comprend une surface de couvercle (32) pouvant être défléchie réalisée dans la première épaisseur de paroi (36) et des parois latérales de couvercle à stabilité de forme (30).

5. Appareil de commande selon la revendication 1, **caractérisé en ce que** des ouvertures (50) se trouvent dans la partie de fond (20) et/ou dans la partie de couvercle (28), par le biais desquelles ouvertures une cavité entre la partie de couvercle (28) et la partie de fond (20) peut être remplie du milieu de remplissage (22) ou la cavité peut être rincée.

6. Appareil de commande selon la revendication 1, **caractérisé en ce que** les trous d'interconnexion (12) sont connectés électriquement au système de connexion de structure modulaire (48), en particulier à une carte de circuits imprimés, une feuille flexible ou une grille estampée, par soudage ou par brasage ou par mise en contact à froid.
